# DEMANDE DE BREVET EUROPEEN

(11) **EP 1 024 546 A1**
(43) Date de publication de la demande: **02.08.2000**
(21) Numéro de dépôt: 00400175.6
(22) Date de dépôt: 24.01.2000
(51) Int. Cl.: H01P 1/04

(54) **Module de circuit hyperfréquence et son dispositif de connexion à un autre module**

(30) Priorité: 28.01.1999 FR 9900936
(71) Demandeur: ALCATEL, 75008 Paris (FR)
(72) Inventeur: Ulian, Patrice, 31310 Latrape (FR); George, Sébastian, 31130 Fonsegrives (FR); Monfraix, Philippe, 31400 Toulouse (FR)
(74) Mandataire: Smith, Bradford Lee

(57) **Abrégé**

L'invention est relative à un module hyperfréquence présentant une face extérieure avec un dispositif de connexion.

Ce module est caractérisé en ce que le dispositif de connexion présente, sur la face extérieure, une zone conductrice centrale (42) et une zone conductrice périphérique (44), et en ce qu'à l'intérieur du volume du module, la connexion au dispositif est réalisée à l'aide de conducteurs coplanaires, comprenant un conducteur central (34) de signal relié à la zone conductrice centrale, et des conducteurs latéraux (36, 38) de masse reliés à la zone conductrice périphérique.

La connexion est favorable à la miniaturisation et permet un fonctionnement à large bande.

## Description

L'invention est relative à un module hyperfréquence et à son dispositif de connexion.

Les circuits hyperfréquences sont utilisés couramment pour des applications diverses notamment pour les télécommunications.

Ces circuits pouvant être utilisés, notamment, pour des applications grand public et des applications spatiales, on cherche à les miniaturiser. Pour réduire la taille de ces circuits on fait, appel à une technologie d'intégration par laquelle on associe un ensemble de circuits selon plusieurs couches formant un ensemble qui est, par exemple, moulé.

Ainsi, un module de circuit hyperfréquence se présente souvent sous la forme d'un solide parallélipipédique ou cubique.

Ces modules doivent être couramment connectés les uns aux autres afin de transmettre des signaux d'un module à un autre, ou afin d'échanger des signaux entre modules.

A titre d'exemple, une antenne active comporte, d'une part, un module hyperfréquence constituant un réseau formateur de faisceau, et, d'autre part, des éléments rayonnants dont chacun est associé à un module hyperfréquence. Ainsi, chaque module associé à un élément rayonnant doit être connecté au module de formation de faisceau.

Les diverses techniques connues de connexion ne permettent, en général, pas de se conformer à deux impératifs importants à savoir un fonctionnement à une fréquence quelconque (c'est à dire sur une large bande de fréquences) et un encombrement minimum. La solution la plus courante pour un fonctionnement sur une très large bande est l'utilisation de connecteurs coaxiaux. Mais ces derniers impliquent, dans le module et à l'extérieur du module, un encombrement difficilement compatible avec la miniaturisation recherchée.

Le module selon l'invention est caractérisé en ce qu'il comporte au moins un dispositif de connexion se présentant sous la forme de zones conductrices, telles que des métallisations, d'une face externe, avec une zone centrale et une zone périphérique, et en ce qu'à l'intérieur du volume du module, la connexion à ces zones conductrices est réalisée à l'aide de conducteurs coplanaires comportant un conducteur central de signal et des conducteurs latéraux de masse.

Ainsi, l'invention combine une technologie de connexion dite coplanaire à l'intérieur du module hyperfréquence à une technologie de type coaxial sur la face de sortie. Une ligne coplanaire et les zones conductrices de type coaxial sur la face de sortie se raccordant de façon continue, il n'en résulte aucune perturbation du champ électromagnétique, et la bande passante n'est donc pas altérée.

Dans un mode de réalisation préféré, les lignes coplanaires internes au module sont sensiblement perpendiculaires à la face de sortie.

Il est à noter qu'à l'intérieur du module, au delà de l'accès, c'est à dire au-delà de la liaison aux zones conductrices, les connexions peuvent être quelconques. Autrement dit, la propagation à l'intérieur du module peut faire appel à tout type de propagation hyperfréquence telles que la technologie triplaque, microruban, guide d'ondes, etc. Il est, bien entendu, également possible de faire appel à des connexions coplanaires.

Sur la face de sortie, les zones conductrices peuvent être constituées par trois zones conductrices séparées, à savoir une zone centrale et deux zones d'extrémité alignées avec la zone centrale.

La zone périphérique peut être constituée aussi par une zone annulaire formant une ligne fermée.

La connexion entre deux modules analogues peut s'effectuer par une connexion coaxiale ou de type coaxial. Dans sa réalisation la plus simple, on relie par soudage la métallisation centrale d'un module à la métallisation centrale de l'autre module, et de même, on relie par soudage les métallisations périphériques.

L'invention prévoit un module hyperfréquence qui présente une face extérieure avec un dispositif de connexion comprenant une zone conductrice centrale et une zone conductrice périphérique. A l'intérieur du volume du module, la connexion au dispositif est réalisée à l'aide de conducteurs coplanaires comprenant, d'une part, un conducteur central de signal relié à la zone conductrice centrale, et, d'autre part, des conducteurs latéraux de masse reliés à la zone conductrice périphérique.

Dans un mode de réalisation, au voisinage de leur connexion aux zones conductrices, les conducteurs coplanaires sont sensiblement perpendiculaires à la face extérieure.

Selon une réalisation, la zone conductrice périphérique de la face extérieure présente la forme d'une ligne ou bande fermée, par exemple de forme sensiblement circulaire. En variante, la zone conductrice périphérique présente deux éléments conducteurs alignés avec l'élément conducteur de la zone centrale.

Dans une réalisation, le conducteur central présente, à son raccordement avec la zone conductrice centrale, une largeur égale à la largeur qu'il présente à l'intérieur du module. On peut aussi prévoir que le conducteur central plan présente, à son raccordement avec la zone conductrice centrale, une largeur qui est différente de la largeur qu'il présente à l'intérieur du module.

La distance entre la zone conductrice centrale et la zone périphérique conductrice peut être égale à, ou différente de, la distance séparant les conducteurs latéraux du conducteur central coplanaire.

Selon un mode de réalisation, les zones conductrices constituent des métallisations, par exemple soudables.

L'invention prévoit aussi un ensemble de deux modules hyperfréquence qui sont raccordés par l'intermédiaire d'un organe de type coaxial comportant une partie centrale reliant les zones conductrices centrales des dispositifs de connexion et un cylindre conducteur extérieur reliant les zones conductrices périphériques des dispositifs de connexion des deux modules.

L'invention prévoit, en outre, un ensemble de deux modules hyperfréquence dans lesquels les zones conductrices constituent des métallisations soudables, ces deux modules étant connectés par l'intermédiaire de points de soudure entre, d'une part, les zones centrales conductrices des deux faces associées et, d'autre part, les zones conductrices périphériques des dispositifs de connexion de chacun des modules.

On prévoit, par exemple, un ensemble de points de soudure formant une couronne pour relier les zones périphériques. En variante, on prévoit, pour relier les zones périphériques, deux points de soudure alignés avec les points de soudure reliant les zones centrales.

D'autres caractéristiques et avantages de l'invention apparaîtront avec la description de certains de ses modes de réalisation, celle-ci étant effectuée en se référant aux dessins ci-annexés sur lesquels :
la figure 1 est un schéma montrant un ensemble de modules hyperfréquence conformes à l'invention,
la figure 2a est une vue schématique en perspective d'une partie de deux modules conformes à l'invention et d'un élément d'assemblage, l'ensemble étant montré avant l'assemblage,
la figure 2b est une vue analogue à celle de la figure 2a montrant les deux modules assemblés,
les figures 3a et 3b sont des vues analogues aux figures, respectivement 2a et 2b, mais pour un autre mode de réalisation, et
les figures 4a et 4b sont également des vues analogues à celles des figures 2a et 2b, mais pour encore un autre mode de réalisation.

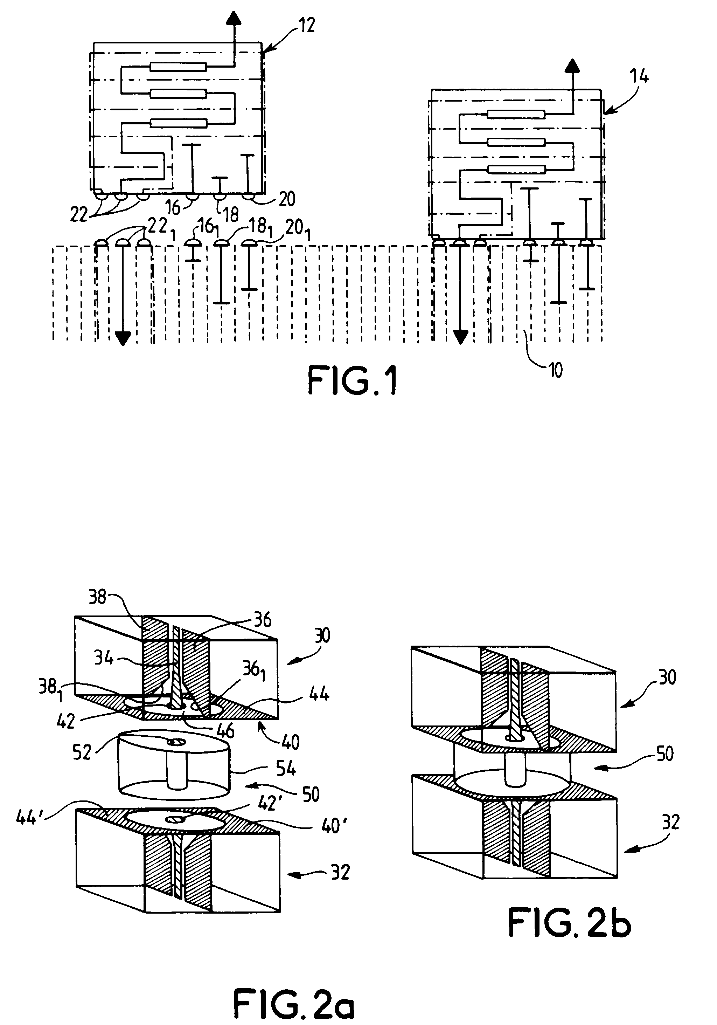

Sur la figure 1, on a représenté de façon schématique des modules 10, 12, 14 d'une antenne active. Chacun de ces modules est de type volumique ou à trois dimensions (3D) et est formé, par exemple, d'un empilement de substrats dont chacun comporte plusieurs circuits intégrés (non représentés), l'ensemble étant moulé.

Ainsi, chacun de ces modules se présente sous la forme d'un parallélépipède ou d'un cube. Les connexions s'effectuent par au moins une face 40 de chacun de ces modules.

Le module 10 est, dans cet exemple, un réseau de formation de faisceau qui est destiné à exciter des éléments rayonnants (non montrés) à chacun desquels est associé un module 12, 14, etc. Chaque module assure une fonction d'alimentation et de traitement hyperfréquence des éléments rayonnants.

Les modules 12 et 14 comportent, par exemple, chacun, un atténuateur, un déphaseur, un amplificateur de puissance ou un amplificateur à faible bruit. Le module 12 est représenté avant assemblage et le module 14 est assemblé au module 10.

L'invention fournit un moyen pour connecter les modules 12, 14, etc.... au module 10, ce moyen n'altérant pas la bande des hyperfréquences à transmettre et recevoir, et présentant un encombrement minimum.

Le module 12 présente, d'une part, des entrées 16, 18, 20 pour des tensions continues de polarisation et, d'autre part, une entrée/sortie hyperfréquence 22 de type pseudo-coaxial conforme à l'invention.

Le module 10 comporte des sorties d'alimentation 16₁, 18₁, 20₁ destinées à être raccordées aux entrées 16, 18 et 20 du module 12. Il présente aussi une entrée/sortie 22₁ destinée à être connectée à l'entrée/sortie 22 du module 12.

Comme on peut le voir sur le module 14, la connexion s'effectue, dans cet exemple, par de simples points de soudure.

Ainsi, une face du module 14 est à très faible distance d'une face du module 10. La connexion est miniaturisée.

Dans les modes de réalisation qui vont maintenant être décrits en relation avec les figures 2a, 2b, 3a, 3b et 4a, 4b, on a représenté seulement la zone des modules à connecter qui se trouve au voisinage des connexions (ou accès) proprement dites.

Dans chacun de ces modes de réalisation, à l'intérieur des modules 30, 32, à proximité des accès, le signal se propage selon des conducteurs dits "coplanaires". Le signal est transmis par une ligne plane 34 qui est entourée, dans le même plan, par des lignes 36 et 38 plus larges (dans l'exemple) constituant des lignes de masse.

Ces conducteurs coplanaires 34, 36, 38 sont, au voisinage de la connexion, perpendiculaires à la face extérieure 40. Cette dernière présente, pour la connexion, des métallisations, ou empreintes, formant une zone centrale conductrice 42 et une zone périphérique 44, en forme de couronne, séparée de la zone centrale par une zone isolante 46.

La zone centrale 42 est connectée à l'extrémité du conducteur 34 de signal, tandis que les bandes 36 et 38 de masse sont connectées à la zone périphérique 44.

Pour la connexion à la zone centrale 42 et à la zone périphérique 44, le conducteur de signal 34 et les bandes 36 et 38 peuvent, à proximité de la face 40, être profilés pour réaliser une adaptation géométrique des lignes 34, 36 et 38 au motif 42 et 44.

Cette adaptation géométrique ne présente pas de difficultés et est à la portée de l'homme de métier. Elle dépend, en particulier, des matières choisies et de l'application envisagée.

Dans l'exemple, le conducteur 34 est, à proximité de la face 40, plus large que sur le reste de sa longueur. Egalement dans l'exemple, à distance de la face 40, les intervalles entre le conducteur central 34 et les conducteurs latéraux 36 et 38 sont étroits, de largeurs inférieures à la "largeur" de la couronne 46. Par "largeur" de la couronne 46 on entend la différence entre le rayon de la zone centrale 42 et le rayon de la zone périphérique 44. Les bandes conductrices 36 et 38 présentent des biseaux, respectivement 36₁ et 38_{1,} tournés vers le conducteur 34 de signal.

Pour la connexion des métallisations du module 30 aux métallisations du module 32, on prévoit, dans l'exemple représenté sur les figures 2a et 2b, un organe 50 d'assemblage de type coaxial comprenant un conducteur central 52 reliant les zones centrales 42 et 42' et un conducteur cylindrique extérieur 54 reliant les zones périphériques 44 et 44'.

La longueur du dispositif d'assemblage 50 perpendiculairement aux faces 40 et 40' peut être minimisée.

Il n'y a pas de perturbations de propagation des signaux entre les deux modules car la propagation est pratiquement homogène, un élément coaxial étant équivalent à un élément coplanaire.

On peut aussi noter, qu'un élément coaxial est obtenu par une révolution d'un élément coplanaire autour de l'axe longitudinal du conducteur 34.

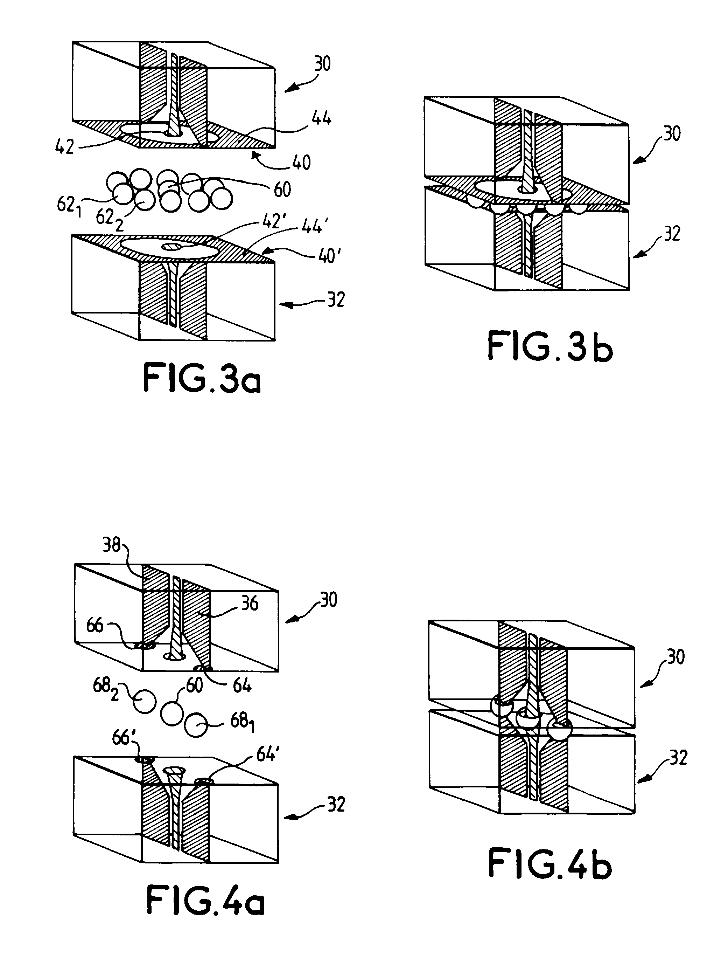

La réalisation représentée sur les figures 3a et 3b se distingue de celle montrée sur les figures 2a et 2b par le fait qu'au lieu de prévoir un élément coaxial 50 on prévoit des points de soudure. Un point de soudure central 60 relie les zones conductrices centrales 42 et 42' des faces 40 et 40' et une couronne de points de soudure 62₁, 62₂, etc.... relie les couronnes conductrices 44 et 44'.

Dans l'exemple représenté sur les figures 4a et 4b, au lieu de prévoir une zone périphérique annulaire continue 44, on prévoit, à la place, deux zones conductrices, 64 et 66, reliées respectivement aux bandes conductrices latérales 36 et 38. La connexion s'effectue par l'intermédiaire de trois points de soudure, un point 60 pour connecter les zones centrales, et deux autres points, 68₁ et 68₂, pour relier les zones 64 et 64' et 66 et 66'. Ce mode de réalisation présente l'avantage de réduire l'encombrement dans le plan de la face 40.

Dans une variante, au lieu de prévoir des métallisations de la face extérieure de la face 40, dans cette dernière on insère des éléments métalliques affleurant cette face extérieure et formant les zones conductrices centrale et périphérique.

## Revendications

1. Module hyperfréquence présentant une face extérieure avec un dispositif de connexion, caractérisé en ce que le dispositif de connexion présente, sur la face extérieure, une zone conductrice centrale (42) et une zone conductrice périphérique (44 ; 64,66), et en ce qu'à l'intérieur du volume du module, la connexion au dispositif est réalisée à l'aide de conducteurs coplanaires, comprenant un conducteur central (34) de signal relié à la zone conductrice centrale, et des conducteurs latéraux (36, 38) de masse reliés à la zone conductrice périphérique.

2. Module selon la revendication 1, caractérisé en ce qu'au voisinage de leur connexion aux zones conductrices, les conducteurs coplanaires sont sensiblement perpendiculaires à la face extérieure.

3. Module selon la revendication 1 ou 2, caractérisé en ce que la zone conductrice périphérique de la face extérieure présente la forme d'une ligne ou bande fermée (44).

4. Module selon revendication 3, caractérisé en ce que la ligne ou bande fermée présente une forme sensiblement circulaire.

5. Module selon la revendication 1 ou 2, caractérisé en ce que la zone conductrice périphérique présente deux éléments conducteurs (64, 66) alignés avec l'élément conducteur (44) de la zone centrale.

6. Module selon l'une quelconque des revendications précédentes, caractérisé en ce que les zones conductrices constituent des métallisations.

7. Module selon la revendication 6, caractérisé en ce que les métallisations sont soudables.

8. Ensemble de deux modules hyperfréquences, caractérisé en ce que chacun de ceux-ci étant selon l'une quelconque des revendications précédentes, ces deux modules (30,32) sont raccordés par l'intermédiaire d'un organe (50) de type coaxial comprenant une partie centrale (52) reliant les zones conductrices centrales des dispositifs de connexion et un cylindre conducteur extérieur (52) reliant les zones conductrices périphériques des dispositifs de connexion des deux modules.

9. Ensemble de deux modules hyperfréquences, caractérisé en ce que chacun de ceux-ci étant selon la revendication 7, ces deux modules sont connectés par l'intermédiaire de points de soudure entre, d'une part, les zones centrales conductrices des deux faces associées et, d'autre part, les zones conductrices périphériques (44, 44') des dispositifs de connexion de chacun des modules.

10. Ensemble selon la revendication 9, caractérisé en ce qu'il comporte un ensemble (62₁, 62₂ ) de points de soudure formant une couronne pour relier les zones périphériques.

11. Ensemble selon la revendication 9, caractérisé en ce qu'il comporte pour relier les zones périphériques deux points (68₁ , 68₂) de soudure alignés avec les points de soudure reliant les zones centrales.
